# EUROPEAN PATENT SPECIFICATION

(11) **EP 4 141 968 B1**
(45) Date of publication and mention of the grant of the patent: **10.04.2024**
(21) Application number: 21200642.3
(22) Date of filing: 04.10.2021
(51) Int. Cl.: H01L 31/0224, H01L 31/05

(54) **PHOTOVOLTAIC CELL AND PHOTOVOLTAIC MODULE**
FOTOVOLTAIKZELLE UND FOTOVOLTAIKMODUL
CELLULE PHOTOVOLTAÏQUE ET MODULE PHOTOVOLTAÏQUE

(30) Priority: 27.08.2021 CN 202110998210
(43) Date of publication of application: 01.03.2023
(60) Divisional application: 23177864.8
(73) Proprietor: Shanghai Jinko Green Energy Enterprise Management Co., Ltd., Shanghai (CN); Zhejiang Jinko Solar Co., Ltd., Haining, Zhejiang 314416 (CN)
(72) Inventor: GUAN, Yingli, Haining, 314416 (CN); HUANG, Shiliang, Haining, 314416 (CN); GUO, Zhiqiu, Haining, 314416 (CN); HAO, Guohui, Haining, 314416 (CN); CAO, Yuncheng, Haining, 314416 (CN)
(74) Representative: DREISS Patentanwälte PartG mbB

(56) References cited:
- US-A1- 2014 318 613
- US-A1- 2019 074 391

## Description

### TECHNICAL FIELD

The present disclosure relates to the field of solar energy technologies, and in particular, to a photovoltaic cell and a photovoltaic module.

### BACKGROUND

With the development of technologies, solar devices such as solar modules have become widely applied clean energy supply devices around the world. Generally, a photovoltaic module includes a plurality of photovoltaic cell strings. Each photovoltaic cell string is formed by a plurality of photovoltaic cells connected through a solder strip. A soldering spot is welded to an electrode pad on the photovoltaic cell to play a role of electrical connection. However, the electrode pad on the photovoltaic cell may shield a surface of the photovoltaic cell, thereby affecting light absorption of the photovoltaic cell and then affecting efficiency of the photovoltaic cell. US 2019/074391 A1 discloses a solar cell panel. The solar cell panel includes: a semiconductor substrate having a long axis and a short axis that intersect; a first conductivity type region formed on one surface of the semiconductor substrate; a second conductivity type region formed on the other surface of the semiconductor substrate; a first electrode electrically connected to the first conductivity type region; and a second electrode electrically connected to the second conductivity type region. The first electrode includes: a plurality of finger lines positioned in a first direction parallel to the long axis and being parallel to each other; and a plurality of bus bars including a plurality of pad portions positioned in a second direction parallel to the short axis. The plurality of pad portions include a first outer pad and a second outer pad located on opposite ends of the plurality of bus bars in the second direction, respectively.

### SUMMARY

The present disclosure relates to a photovoltaic cell and a photovoltaic module.

Embodiments of the present disclosure relate to a photovoltaic cell. The photovoltaic cell, as defined in independent claim 1 of the appended set of claims, comprises: a substrate; a passivation layer located on at least one surface of the substrate; busbars and fingers intersecting with each other on a surface of the substrate, wherein the busbars are electrically connected to the fingers. A quantity of the busbars is 10 to 15. A plurality of electrode pads is arranged on a surface of the substrate, wherein each busbar is connected to 4 to 6 electrode pads. The 4 to 6 electrode pads include first electrode pads and second electrode pads. The first electrode pads are located on two ends of the busbars, and the second electrode pads are located between the first electrode pads. The first electrode pads each have an area of 0.6 mm2 to 1.3 mm2 , and the second electrode pads each have an area of 0.2 mm2 to 0.5 mm2 . Each of the second electrode pads is in contact with one of the busbars and is not in contact with the fingers.

In an embodiment, the at least one busbar and/or the at least one finger has a dimension less than or equal to 10 µm along a thickness direction of the photovoltaic cell, and/or the first electrode pads and/or the second electrode pads each have a dimension less than or equal to 8 µm along the thickness direction of the photovoltaic cell.

In an embodiment, the first electrode pads and/or the second electrode pads each have a shape of any one of a rectangle, a rhombus, a circle, an ellipse or combinations thereof.

In an embodiment, the first electrode pads each have a length and a width respectively between 0.3 mm and 1.1 mm.

In an embodiment, the second electrode pads each have a length and a width respectively between 0.4 mm and 0.8 mm.

In an embodiment, when the substrate is an N-type semiconductor, the at least one busbar has a width of 20 µm to 45 µm.

In an embodiment, when the substrate is a P-type semiconductor, the quantity of the busbar is 10 to 13.

In an embodiment, when the substrate is a P-type semiconductor, the at least one busbar has a width of 40 µm to 60 µm.

The present disclosure further provides a photovoltaic module. The photovoltaic module includes glass, a first film material, a photovoltaic cell string, a second film material, and a back sheet sequentially from a front side to a back side, wherein the photovoltaic cell string includes a plurality of photovoltaic cells, and each of the plurality of photovoltaic cells is the photovoltaic cell according to the above aspect.

In an embodiment, the plurality of photovoltaic cells are connected through an electrode line, and the electrode line has a diameter of 0.25 mm to 0.32 mm.

In an embodiment, the first film material and/or the second film material has a weight of 300 g/m² to 500 g/m².

It is to be understood that the general description above and the detailed description in the following are merely illustrative, which shall not be interpreted as limiting the present disclosure.

### BRIEF DESCRIPTION OF DRAWINGS

FIG. 1 is a schematic structural diagram of a photovoltaic cell according to an embodiment of the present disclosure;
FIG. 2 is a partial enlarged view of Position I in FIG. 1;
FIG. 3 is a schematic structural diagram of a first electrode pad according to an embodiment of the present disclosure;
FIG. 4 is a schematic structural diagram of an embodiment of a second electrode pad according to an embodiment of the present disclosure;
FIG. 5 is a schematic structural diagram of another embodiment of the second electrode pad according to an embodiment of the present disclosure;
FIG. 6 is a schematic structural diagram of yet another embodiment of the second electrode pad according to an embodiment of the present disclosure;
FIG. 7 shows a comparison table of embodiments and the related art according to an embodiment of the present disclosure; and
FIG. 8 is a schematic diagram of a relationship between consumption of silver paste and the number of busbars according to an embodiment of the present disclosure.

### Reference signs:

1: busbar;
2: finger;
3: electrode pad;
   31: first electrode pad;
   32: second electrode pad.

The accompanying drawings herein, which are incorporated in and constitute a part of this specification, illustrate embodiments consistent with the present disclosure and, together with the specification, serve to explain principles of the present disclosure.

### DESCRIPTION OF EMBODIMENTS

In order to better understand the technical solutions of the present disclosure, embodiments of the present disclosure are described in detail below with reference to the accompanying drawings.

It should be made clear that the described embodiments are merely some of rather than all of the embodiments of the present disclosure.

The terms used herein in the embodiments of the present disclosure are intended only to describe specific embodiments, and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means that associated objects therebefore and thereafter are in an "or" relationship.

It is to be noted that orientation words such as "up", "down", "left" and "right" described in the embodiments of the present disclosure are described from the angles as shown in the accompanying drawings and should not be understood as limitations to the embodiments of the present disclosure. In addition, in the context, it is to be further understood that, when one element is connected "above" or "below" another element, it can be directly connected "above" or "below" another element, and can be indirectly connected "above" or "below" the another element through an intermediate element.

With the development of technologies, photovoltaic cells have become common solar devices, and the photovoltaic cells may generally be classified into N-type photovoltaic cells and P-type photovoltaic cells. When energy (for example, heat) is added to pure silicon, several electrons may break away from their covalent bonds and leave atoms. Every time an electron leaves, a hole is left. Then, the electrons may wander around lattices, searching for another hole to settle into. The electrons are called free carriers, which can carry currents. When the pure silicon is mixed with phosphorus atoms, only very little energy is required to allow an "extra" electron of the phosphorus atoms (the outermost five electrons) to escape. When the phosphorus atoms are used for doping, the resulting silicon is N-type, and the solar cell is only partially N-type. The other part of silicon is doped with boron which has only three electrons in its outermost electron layer instead of four, resulting in P-type silicon. The P-type silicon has no free electrons. Phosphorus is diffused on a p-type semiconductor material to form a solar cell of a pin-type structure, i.e., a P-type silicon wafer. Boron is diffused on an N-type semiconductor material to form a solar cell of an n/p-type structure, i.e., an N-type silicon wafer.

An N-type photovoltaic cell includes an N-type silicon wafer, which uses electrons to conduct electricity. A P-type photovoltaic cell includes a P-type silicon wafer, which uses holes to conduct electricity. Generally, silver paste is provided on two sides of the N-type photovoltaic cell. In one possible implementation, the N-type photovoltaic cell may be a Tunnel Oxide Passivated Contact (TOPCon) cell. A substrate of the TOPCon cell is an N-type semiconductor. The substrate has a back side sequentially provided with a superwave tunnel oxide layer, N-type polycrystalline silicon, a backside passivation layer and a metal electrode, and the other side provided with a boron-doped diffusion layer and a metal electrode.

The P-type photovoltaic cell has one side provided with silver paste and the other side provided with aluminum paste and silver paste in combination. In one possible implementation, the P-type photovoltaic cell may be a Passivated Emitter and Rear Contact (PERC) cell. A substrate of the PERC cell is a P-type semiconductor, and the substrate has a front side provided with a passivation layer and a silver electrode and the other side provided with a passivation layer, an aluminum electrode and a silver electrode.

The N-type photovoltaic cell has a longer service life and higher efficiency. The P-type photovoltaic cell is simple in process and low in cost.

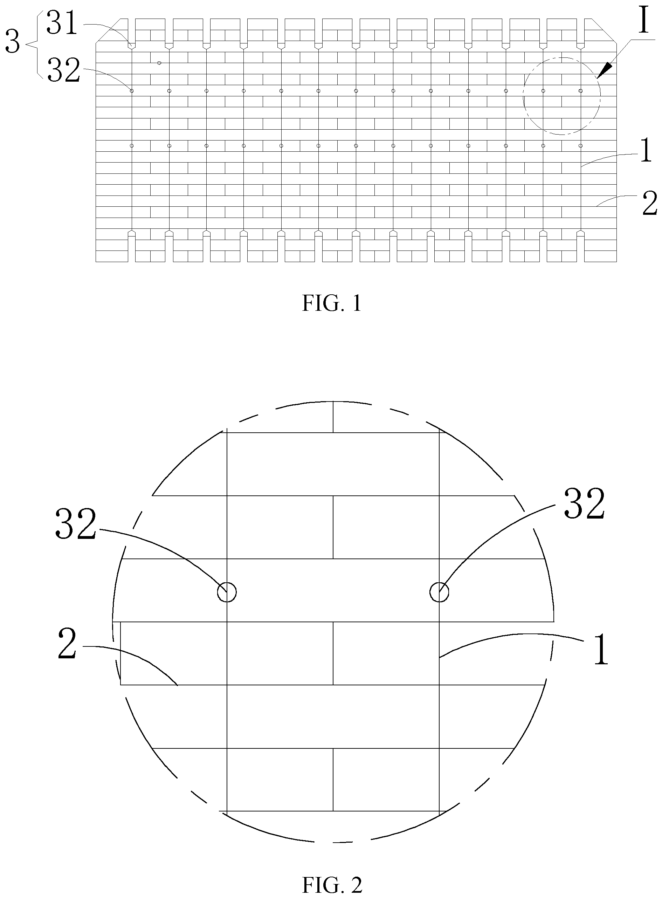

As shown in FIG. 1 and FIG. 2, the present disclosure relates to a photovoltaic cell. The photovoltaic cell includes a substrate and a passivation layer located on a surface of the substrate. The photovoltaic cell converts light energy to electric energy through a PN junction. The PN junction may be manufactured by diffusion to form a diffusion layer. The manufacturing of the passivation layer may increase light conversion efficiency of the photovoltaic cell. The photovoltaic cell further includes a busbar 1 and a finger 2 intersecting with each other on the surface of the substrate. The busbar 1 is electrically connected to the finger 2. The finger 2 is electrically connected to the substrate and configured to collect a current generated by the substrate. The busbar 1 is configured to collect a current from the finger 2. The number of the busbar 1 is 10 to 15, which may be for example 10, 11, 12, 13, 14 or 15. The photovoltaic cell further includes an electrode pad 3 arranged on the surface of the substrate. The number of the electrode pad 3 is 4, 5 or 6. The electrode pad 3 includes first electrode pads 31 and second electrode pads 32. The first electrode pads 31 are located on two ends of the busbar 1. The second electrode pads 32 are located between the first electrode pads 31. The first electrode pad 31 has an area of 0.6 mm² to 1.3 mm², which may be for example 0.6 mm², 0.7 mm², 0.8 mm², 0.9 mm², 1.0 mm², 1.1 mm², 1.2 mm² or 1.3 mm². The second electrode pad 32 has an area of 0.2 mm² to 0.5 mm², which may be for example 0.2 mm², 0.25 mm², 0.3 mm², 0.35 mm², 0.4 mm², 0.45 mm² or 0.5 mm².

The photovoltaic cell according to embodiments of the present disclosure may be applied to solar cells in a size range of 160 mm to 170 mm, which may be applied to, for example, common solar cells with sizes of 161.75 mm, 163.75 mm, 166 mm and the like.

In the existing solution, the number of the busbar 1 is generally 5 to 9. In the present invention, the number of the busbar 1 is set to 10 to 15. An area of a single busbar 1 responsible for current transfer is reduced by increasing the number of the busbar 1 and reducing a spacing between the busbars 1, thereby reducing a current passing through the single busbar 1. Generally, the internal loss of the photovoltaic cell is mainly heat generated during operation. According to a formula Q=I²Rt, where Q is the heat generated during operation, i.e., main internal loss, Iis current, R is resistance, and t is operation time. When the current in the circuit decreases, the heat generated is reduced under conditions of constant resistance and fixed operation time, that is, the internal loss is reduced, so as to help improve the overall conversion efficiency of the photovoltaic cell.

Generally, conventional solar cells of a 160+ model are mostly half-cut, provided with seven or more soldering spots. In the present invention, the number of the electrode pad 3 of the half-cut photovoltaic cell is reduced to 4 to 6 compared with the conventional solution in the art. Moreover, the first electrode pad 31 has an area set to 0.6 mm² to 1.3 mm², and the second electrode pad 32 has an area of 0.2 mm² to 0.5 mm². The first electrode pads 31 may be arranged on two opposite sides of the busbar 1. The second electrode pads 32 are located between the first electrode pads 31. Since the first electrode pads 31 are located two opposite ends of the busbar 1, the busbar 1 is generally a straight line. Therefore, when the first electrode pad 31 is successfully welded, positions of the busbar 1 and the solder strip are also relatively fixed.

In an embodiment according to the present disclosure, the number of the busbar 1 is increased, and the current to be collected by a single busbar 1 is reduced. Therefore, a width of each busbar 1 may be reduced, and a diameter of an electrode line may be reduced accordingly. Therefore, the number and the area of the electrode pad 3 required are also relatively reduced while a soldering yield and required soldering pull force are ensured, so as to reduce consumption of the silver paste and help to reduce cost.

In an embodiment of the present disclosure, the shielding of the electrode pad 3 for the substrate can be reduced by adjusting the number and the area of the electrode pad 3, so as to reduce the influence of the electrode pad 3 on light absorption of the substrate and improve operation efficiency of the photovoltaic cell. At the same time, when the area of the electrode pad 3 is reduced, consumed silver paste may also be reduced accordingly, thereby reducing the cost.

The electrode pad 3 is set to a shape of a rectangle, a rhombus, a circle, an ellipse or the like, which can reduce the area of the electrode pad 3 compared with a conventional square structure. This design can reduce the shielding for the substrate, and reduce the consumption of the silver paste and reduce the cost.

In one possible implementation solution, the busbar 1 of the photovoltaic cell with an N-type semiconductor substrate has a width of 20 µm to 45 µm, for example, 20 µm, 25 µm, 30 µm, 35 µm, 40 µm, 45 µm or the like.

In one possible implementation solution, the number of the busbar 1 of the photovoltaic cell with a P-type semiconductor substrate is 10, 11, 12 or 13. The busbar 1 has a width of 40 µm to 60 µm, for example, 40 µm, 45 µm, 50 µm, 55 µm, 60 µm or the like.

The number of the busbar 1 is increased by adjusting the width of the busbar 1, which can reduce the shielding of the busbar 1 for the substrate, so as to facilitate the substrate absorbing light, thereby improving the operation efficiency of the photovoltaic cell.

Although the decrease in the width of the busbar 1 may lead to an increase in resistance of a single busbar 1, the increased resistance affects the amount of heat generated less than the decrease of the current. Therefore, the overall amount of heat generated of the photovoltaic cell is still reduced compared with the conventional solution.

In one possible implementation, the busbar 1 and/or the finger 2 have/has a dimension less than or equal to 10 µm along a thickness direction of the photovoltaic cell, and/or the first electrode pad 31 and/or the second electrode pad 32 have/has a dimension less than or equal to 8 µm along the thickness direction of the photovoltaic cell.

Compared with a conventional solution, the busbar 1 and/or the finger 2 is reduced in thickness, so that the busbar 1 and/or the finger 2 is reduced in volume; and/or dimensions of the first electrode pad 31 and the second electrode pad 32 along the thickness direction of the photovoltaic cell are reduced, so that the electrode pad 3 is reduced in volume, which may reduce silver paste materials and reduce manufacturing cost.

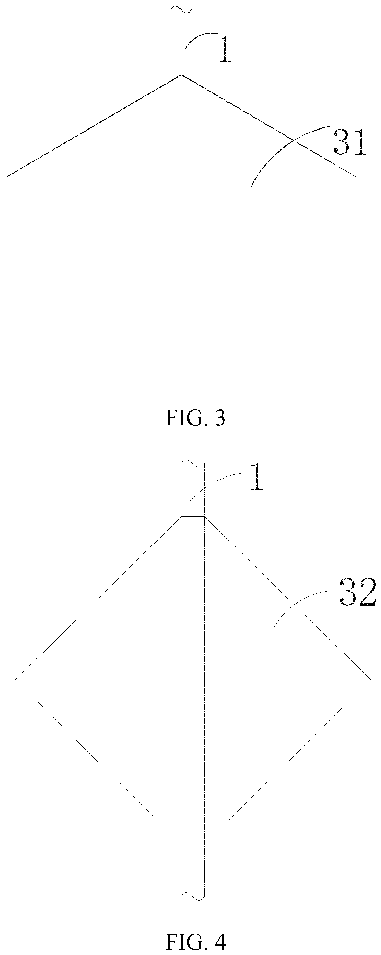

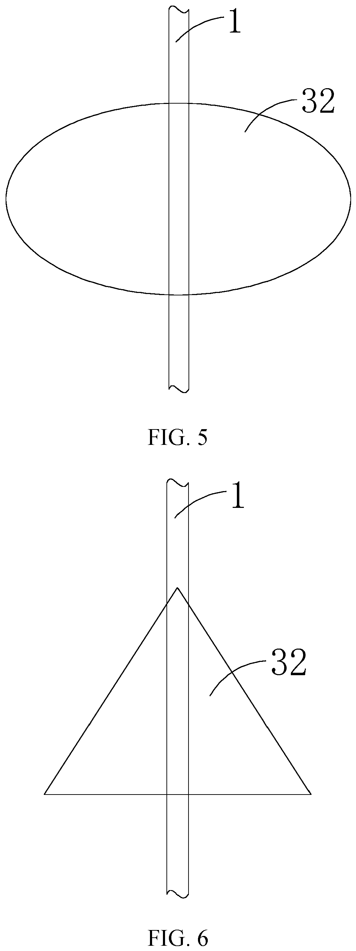

As shown in FIG. 3 to FIG. 6, in one possible implementation, the first electrode pad 31 and/or the second electrode pad 32 is in a shape of one of a rectangle, a rhombus, a circle and an ellipse or combinations thereof.

The setting of the shape of the first electrode pad 31 and/or the second electrode pad 32, while ensuring connection strength, reduces the area and the shielding area, improves operation efficiency and, at the same time, reduces consumption of silver paste and the manufacturing cost.

In one possible implementation, the first electrode pad 31 has a length and a width respectively between 0.3 mm and 1.1 mm, for example, 0.3 mm, 0.4 mm, 0.5 mm, 0.6 mm, 0.7 mm, 0.8 mm, 0.9 mm, 1.0 mm, 1.1 mm, or the like.

In one possible implementation, the second electrode pad 32 has a length and a width respectively between 0.4 mm and 0.8 mm, for example, 0.4 mm, 0.5 mm, 0.6 mm, 0.7 mm, 0.8 mm, or the like.

When the length and the width correspond to the electrode pad 3 in an elliptical shape, a length range corresponds to a major-axis range of the elliptical shape, and a width range corresponds to a minor-axis range of the elliptical shape.

According to the solution, the lengths and the widths of the first electrode pad 31 and the second electrode pad 32 are reduced, which reduces the area of the electrode pad 3 on the premise of sufficient connection strength, reduces the consumption of the silver paste, lowers the manufacturing cost, and reduces the shielding area of the electrode pad 3, thereby improving the operation efficiency of the photovoltaic cell.

In the present invention, the second electrode pad 32 is in contact with the busbar 1 and is not in contact with the finger 2. That is, the second electrode pad 32 is not arranged at a position where the first electrode pad 31 and the second electrode pad 32 are connected to each other.

This design can reduce the possibility that normal use of the photovoltaic cell is affected by busbar breakage at a position of connection between the busbar 1 and the finger 2 caused by soldering, which is more in line with actual use requirements.

In one possible implementation solution, the finger 2 of the photovoltaic cell with the N-type semiconductor substrate has a width of 20 µm to 40 µm. The number of the finger 2 is 80 to 100, for example, 80, 90 or 100. The width of the busbar 1 may be the same as the finger 2.

In one possible implementation solution, the finger 2 of the photovoltaic cell with the P-type semiconductor substrate has a width of 20 µm to 45 µm. T number of the finger 2 is 100 to 150, for example, 110, 120, 130, 140, 150 or the like.

In one possible implementation, the P-type photovoltaic cell may have a front surface provided with 109 to 123 fingers 2 and a back surface provided with 123 to 139 fingers 2. Silver, which is expensive, is used on the front surface of the P-type photovoltaic cell to conduct electricity. Therefore, the number of the finger 2 may be reduced appropriately, and aluminum, which is less expensive, and a small amount of silver are used on the back surface to conduct electricity. Therefore, the number of the finger 2 may be appropriately increased on the back surface to improve the operation efficiency of the photovoltaic cell.

In the solution according to an embodiment of the present disclosure, the shielding of the finger 2 for the substrate can be reduced by reducing the number of the finger 2, so as to facilitate the substrate absorbing light and improve the operation efficiency of the photovoltaic cell.

Compared with the conventional solution, according to the present disclosure, the busbar 1 has a narrower width and a larger quantity, the electrode pad 3 has a smaller quantity (a smaller number of soldering pads), and the electrode pad 3 has a smaller area, which can reduce the consumption of the silver paste and help reduce the cost.

The present disclosure relates to a photovoltaic module. The photovoltaic module includes glass, a first film material, a photovoltaic cell string, a second film material, and a back sheet sequentially from front to back, wherein the photovoltaic cell string includes a plurality of photovoltaic cells, and the photovoltaic cell is the photovoltaic cell described in any item above.

The glass on the front surface of the photovoltaic cell protects and transmits light. The first film material and the second film material are configured to bond and fix the glass and the photovoltaic cell string. The photovoltaic cell string is configured to convert light energy into electric energy. The back sheet has functions of sealing, insulation and water resistance.

In one possible implementation, the photovoltaic cells are connected through an electrode line. The electrode line has a diameter of 0.25 mm to 0.32 mm, for example, 0.25 mm, 0.26 mm, 0.27 mm, 0.28 mm, 0.29 mm, 0.30 mm, 0.31 mm, 0.32 mm or the like.

Compared with the existing solution, a thinner electrode line is used, and an area of shielding of the solder strip for the cell is reduced, which improves the operation efficiency of the cell.

In one possible implementation, the electrode line may be partially flattened to form a flat structure at a position where the electrode line corresponds to the electrode pad 3. This design can increase a contact area between the electrode line and electrode pad 3 when the electrode line is in contact with the electrode pad 3. In another possible implementation, the flat structure is formed at a position where the electrode line corresponds to the first electrode pad 31, because the first electrode pad serves as a main electrode pad.

In one possible implementation, the first film material and/or the second film material have/has a weight of 300 g/m² to 500 g/m².

Compared with the existing solution, in an embodiment according to the present disclosure, less silver paste is consumed, the electrode line is thinner, the electrode line is less reduced, the electrode line is less likely to puncture the film material, and thus the first film material and/or the second film material with less grammage, for example, ethylene vinyl acetate (EVA) or polyolefin elastomer (POE), may be selected, so as to reduce the manufacturing cost.

It is to be noted herein that the data exemplified in the present disclosure are only preferred and common data within the data range according to an embodiment of the present disclosure, and the rest is not listed. However, data within the data range according to the present disclosure can achieve the corresponding technical effect.

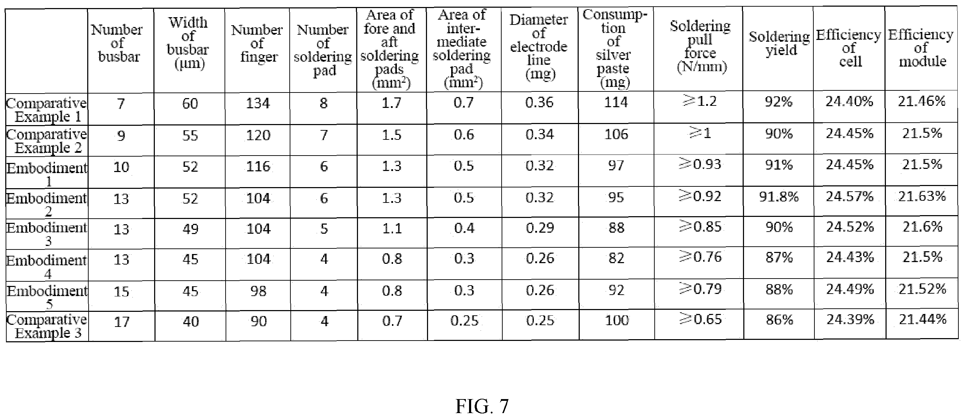

As shown in FIG. 7, the following table is obtained upon test. The embodiments are solutions according to the present disclosure, which are specifically technical effects achieved by a 163 cell, and the comparative examples are existing conventional solutions. It may be obtained from Comparative Example 1, Comparative Example 2 and Embodiment 1 to Embodiment 5 that, the number of the finger 2 may be reduced when the number of the busbar 1 is increased, and the current to be collected by a single busbar 1 is reduced when the number of the busbar 1 is increased. Therefore, a width of each busbar 1 may be reduced, and the diameter of the electrode line may be reduced at the same time. Therefore, the number and the area of the electrode pad 3 required are also relatively reduced while a soldering yield and required soldering pull force are ensured, so as to effectively reduce cost. Generally, processing requirements may be met when a minimum value of the soldering pull force is greater than 0.75 N. It may be known from the table that compared with Comparative Examples 1 and 2, Embodiments 1 to 5 can still meet the requirements of the soldering pull force while reducing the consumption of the silver paste and reducing the cost, which has a soldering yield fluctuating slightly, so as to meet actual use requirements. At the same time, it may be obtained from the data in the table that, compared with the comparative examples, the embodiments further improve the efficiency of the cell and the efficiency of the module while reducing the cost, which is more in line with the actual use requirements.

It may be obtained from Embodiments 2 to 4 that, when the number of the busbar 1 and the number of the finger 2 are fixed, if the width of the busbar 1 is smaller, the number of the soldering spot is smaller, the area is smaller, and less silver paste is consumed. At the same time, the width of the busbar 1 is reduced, and the diameter of the electrode line may also be relatively reduced. Therefore, less silver paste is consumed.

It may be obtained from Embodiments 4 and 5 that, when the area of the electrode pad 3 is fixed, even if the number of the finger 2 is reduced, the consumption of the silver paste may also be increased due to the increase in the number of the busbar 1. Therefore, the number of the busbar 1 has greater influence on the consumption of the silver paste than the number of the finger 2.

In the solution according to the present disclosure, the number of the busbar 1 ranges from 10 to 15. When the number of the busbar 1 exceeds 15, it may be obtained from Embodiments 1 to 5 and Comparative Example 3 that, in Comparative Example 3, the number of the busbar 1 is increased, the width is reduced, and the area of the soldering spot is reduced. In this case, although the number of the finger 2 is reduced, the consumption of the silver paste is increased due to an excessive number of the busbar 1. Moreover, the soldering pull force cannot meet the processing requirements, and the efficiency of the cell and the efficiency of the module are evidently reduced compared with each embodiment, so the cost performance is low in actual use, which does not meet actual manufacturing and use requirements.

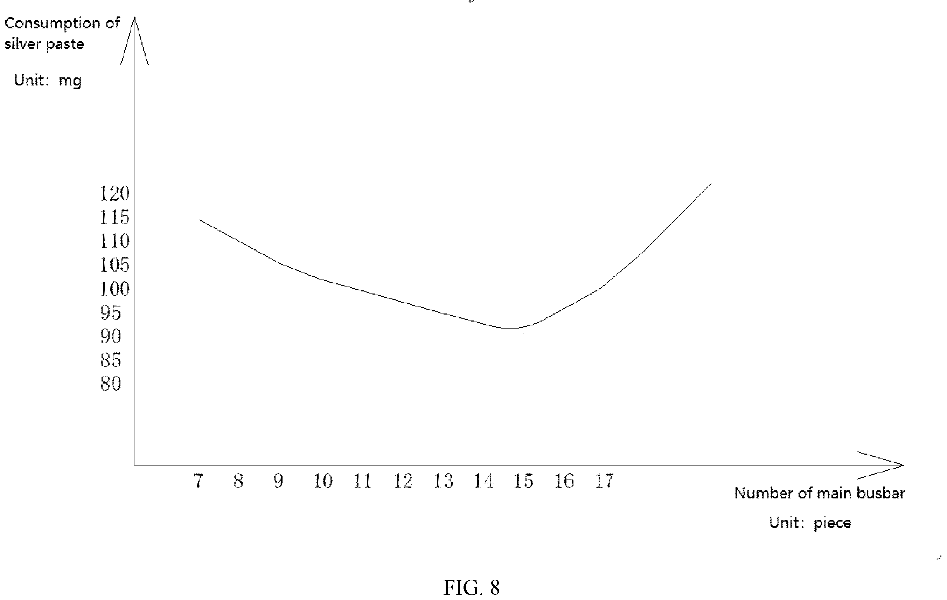

As shown in FIG. 8, with an increase in the number of the busbar 1 and a decrease in the number of the finger 2, a curve of the consumption of the silver paste is an inverse parabola. When the number of the busbar 1 exceeds 15, a reduction in the silver paste caused by the decrease in the number of the finger 2 is less than an increase in the silver paste caused by the increase in the number of the busbar 1. Overall, the consumption of the silver paste increases significantly, which increases the cost, and reduces the soldering yield, and the efficiency of the cell and the efficiency of the module to some extent.

The above are only preferred embodiments of the present disclosure and are not intended to limit the present disclosure. For those skilled in the art, the present disclosure may have various modifications and variations.

## Claims

1. A photovoltaic cell, comprising:
a substrate;
a passivation layer located on at least one surface of the substrate;
busbars (1) and fingers (2) intersecting with each other on a surface of the substrate, wherein the busbars (1) are electrically connected to the fingers (2), and a quantity of the busbars (1) is 10 to 15; and
a plurality of electrode pads (3) arranged on a surface of the substrate, wherein each busbar is connected to 4 to 6 electrode pads (3), the 4 to 6 electrode pads (3) include first electrode pads (31) and second electrode pads (32), the first electrode pads (32) are located on two ends of the busbars (1), the second electrode pads (32) are located between the first electrode pads (31), the first electrode pads (31) each have an area of 0.6 mm² to 1.3 mm², and the second electrode pads (32) each have an area of 0.2 mm² to 0.5 mm²;.
wherein the photovoltaic cell is **characterized in that**:
each of the second electrode pads (32) is in contact with one of the busbars (1) and is not in contact with the fingers (2).

2. The photovoltaic cell according to claim 1, **characterized in that**, the busbars (1) and/or the fingers (2) each has a dimension less than or equal to 10 µm along a thickness direction of the photovoltaic cell, and/or
the first electrode pads (31) and/or the second electrode pads (32) each have a dimension less than or equal to 8 µm along the thickness direction of the photovoltaic cell.

3. The photovoltaic cell according to claim 1, **characterized in that**, the first electrode pads (31) and/or the second electrode pads (32) each have a shape of any one of a rectangle, a rhombus, a circle, an ellipse or combinations thereof.

4. The photovoltaic cell according to claim 3, **characterized in that**, the first electrode pads (31) each have a length and a width respectively between 0.3 mm and 1.1 mm, and
the second electrode pads (32) each have a length and a width respectively between 0.4 mm and 0.8 mm.

5. The photovoltaic cell according to claim 1, **characterized in that**, when the substrate is an N-type semiconductor, each of the busbars (1) has a width of 20 µm to 45 µm.

6. The photovoltaic cell according to claim 1, **characterized in that**, when the substrate is a P-type semiconductor, the quantity of the busbars (1) is 10 to 13.

7. The photovoltaic cell according to claim 1, **characterized in that**, when the substrate is a P-type semiconductor, each of the busbars (1) has a width of 40 µm to 60 µm.

8. The photovoltaic cell according to claim 3, **characterized in that**, the second electrode pads (32) each have a length and a width respectively between 0.4 mm and 0.7 mm.

9. A photovoltaic module, **characterized in that**, the photovoltaic module comprises glass, a first film material, a photovoltaic cell string, a second film material, and a back sheet sequentially from a front side to a back side, wherein the photovoltaic cell string comprises a plurality of photovoltaic cells, and each of the plurality of photovoltaic cells is the photovoltaic cell according to any one of claims 1 to 8.

10. The photovoltaic module according to claim 9, **characterized in that**, the plurality of photovoltaic cells are connected through an electrode line, and the electrode line has a diameter of 0.25 mm to 0.32 mm.

11. The photovoltaic module according to claim 9, **characterized in that**, the first film material and/or the second film material has a weight of 300 g/m² to 500 g/m².

## Patentansprüche

1. Photovoltaische Zelle, umfassend:
ein Substrat;
eine Passivierungsschicht, die auf mindestens einer Oberfläche des Substrats angeordnet ist;
Busbars (1) und Finger (2), die sich jeweils auf einer Oberfläche des Substrats überschneiden, wobei die Busbars (1) mit den Fingern (2) elektrisch verbunden sind und eine Anzahl der Busbars (1) zehn bis fünfzehn beträgt; und
eine Vielzahl von Elektrodenpads (3), die auf einer Oberfläche des Substrats angeordnet sind, wobei jede Busbar mit vier bis sechs Elektrodenpads (3) verbunden ist, wobei die vier bis sechs Elektrodenpads (3) erste Elektrodenpads (31) und zweite Elektrodenpads (32) umfassen, wobei die ersten Elektrodenpads (32) an zwei Enden der Busbars (1) angeordnet sind, die zweiten Elektrodenpads (32) zwischen den ersten Elektrodenpads (31) angeordnet sind, die ersten Elektrodenpads (31) jeweils eine Fläche von 0.6 mm² bis 1.3 mm² aufweisen, und wobei die zweiten Elektrodenpads (32) jeweils eine Fläche von 0.2 mm² bis 0.5 mm² aufweisen;
wobei die photovoltaische Zelle **dadurch gekennzeichnet ist, dass** jedes der zweiten Elektrodenpads (32) in Kontakt mit einer der Busbars (1) steht und nicht in Kontakt mit den Fingern (2) steht.

2. Photovoltaische Zelle nach Anspruch 1, **dadurch gekennzeichnet, dass** die Busbars (1) und/oder die Finger (2) jeweils eine Abmessung von weniger als oder gleich 10 µm entlang einer Dickenrichtung der photovoltaischen Zelle aufweist, und/oder
die ersten Elektrodenpads (31) und/oder die zweiten Elektrodenpads (32) jeweils eine Abmessung von weniger als oder gleich 8 µm entlang der Dickenrichtung der photovoltaischen Zelle aufweisen.

3. Photovoltaische Zelle nach Anspruch 1, **dadurch gekennzeichnet, dass** die ersten Elektrodenpads (31) und/oder die zweiten Elektrodenpads (32) jeweils eine Form eines Rechtecks, einer Raute, eines Kreises, einer Ellipse oder Kombinationen davon aufweisen.

4. Photovoltaische Zelle nach Anspruch 3, **dadurch gekennzeichnet, dass** die ersten Elektrodenpads (31) jeweils eine Länge und eine Breite zwischen 0.3 mm und 1.1 mm aufweisen, und dass die zweiten Elektrodenpads (32) jeweils eine Länge und eine Breite zwischen 0.4 mm und 0.8 mm aufweisen.

5. Photovoltaische Zelle nach Anspruch 1, **dadurch gekennzeichnet, dass** wenn das Substrat ein N-Typ Halbleiter ist, jede der Busbars (1) eine Breite von 20 µm bis 45 µm aufweist.

6. Photovoltaische Zelle nach Anspruch 1, **dadurch gekennzeichnet, dass** wenn das Substrat ein P-Typ Halbleiter ist, die Anzahl der Busbars (1) Zehn bis Dreizehn beträgt.

7. Photovoltaische Zelle nach Anspruch 1, **dadurch gekennzeichnet, dass** wenn das Substrat ein P-Typ Halbleiter ist, jede der Busbars (1) eine Breite von 40 µm bis 60 µm aufweist.

8. Photovoltaische Zelle nach Anspruch 3, **dadurch gekennzeichnet, dass** die zweiten Elektrodenpads (32) jeweils eine Länge und eine Breite zwischen 0.4 mm and 0.7 mm aufweisen.

9. Photovoltaisches Modul, **dadurch gekennzeichnet, dass** das photovoltaische Modul von einer Vorderseite zu einer Rückseite aufeinanderfolgend ein Glas, ein erstes Filmmaterial, einen photovoltaischen Zellenstrang, ein zweites Filmmaterial und eine Rückseitenlage umfasst, wobei der photovoltaische Zellenstrang eine Vielzahl von photovoltaischen Zellen umfasst und jede der photovoltaischen Zellen eine photovoltaischen Zelle gemäß einem der Ansprüche 1 bis 8 ist.

10. Photovoltaisches Modul nach Anspruch 9, **dadurch gekennzeichnet, dass** die Vielzahl von photovoltaische Zellen durch eine Elektrodenleitung verbunden sind und die Elektrodenleitung einen Durchmesser von 0.25 mm bis 0.32 mm aufweist.

11. Photovoltaisches Modul nach Anspruch 10, **dadurch gekennzeichnet, dass** das erste Filmmaterial und/oder das zweite Filmmaterial ein Gewicht von 300 g/m² bis 500 g/m² aufweist.

## Revendications

1. Cellule photovoltaïque, comprenant :
un substrat ;
une couche de passivation située sur au moins une surface du substrat ;
des barres omnibus (1) et des doigts (2) se croisant sur une surface du substrat, dans lequel les barres omnibus (1) sont connectées électriquement aux doigts (2), et une quantité de barres omnibus (1) comprise entre 10 et 15 ; et
une pluralité de pastilles d'électrodes (3) disposées sur une surface du substrat, dans lequel chaque barre omnibus est connecté à 4 à 6 pastilles d'électrodes (3), les 4 à 6 pastilles d'électrodes (3) comprenant des premières pastilles d'électrodes (31) et des secondes pastilles d'électrodes (32), les premières pastilles d'électrodes (31) étant situées sur deux extrémités des barres omnibus (1), les secondes pastilles d'électrodes (32) étant situées entre les premières pastilles d'électrodes (31), les premières pastilles d'électrodes (31) ayant chacune une surface comprise entre 0,6 mm² et 1,3 mm², et les secondes pastilles d'électrodes (32) ayant chacune une surface comprise entre 0,2 mm² et 0,5 mm² ;
dans lequel la cellule photovoltaïque est **caractérisée en ce que** :
chacune des secondes pastilles d'électrodes (32) est en contact avec une des barres omnibus (1) et n'est pas en contact avec les doigts (2).

2. Cellule photovoltaïque selon la revendication 1, **caractérisée en ce que** les barres omnibus (1) et/ou les doigts (2) ont chacun une dimension inférieure ou égale à 10 µm le long d'une direction de l'épaisseur de la cellule photovoltaïque, et/ou
les premières pastilles d'électrodes (31) et/ou les secondes pastilles d'électrodes (32) ont chacune une dimension inférieure ou égale à 8 µm le long de la direction de l'épaisseur de la cellule photovoltaïque.

3. Cellule photovoltaïque selon la revendication 1, **caractérisée en ce que** les premières pastilles d'électrodes (31) et/ou les secondes pastilles d'électrodes (32) ont chacune une forme d'un rectangle, d'un losange, d'un cercle, d'une ellipse ou d'une combinaison de celles-ci.

4. Cellule photovoltaïque selon la revendication 3, **caractérisée en ce que** les premières pastilles d'électrodes (31) ont chacune une longueur et une largeur respectivement comprises entre 0,3 mm et 1,1 mm, et les secondes pastilles d'électrodes (32) ont chacune une longueur et une largeur respectivement comprises entre 0,4 mm et 0,8 mm.

5. Cellule photovoltaïque selon la revendication 1, **caractérisée en ce que**, lorsque le substrat est un semiconducteur de type N, chacune des barres omnibus (1) a une largeur comprise entre 20 µm et 45 µm.

6. Cellule photovoltaïque selon la revendication 1, **caractérisée en ce que**, lorsque le substrat est un semiconducteur de type P, la quantité de barres omnibus (1) est comprise entre 10 et 13.

7. Cellule photovoltaïque selon la revendication 1, **caractérisée en ce que**, lorsque le substrat est un semiconducteur de type P, chacune des barres omnibus (1) a une largeur comprise entre 40 µm et 60 pm.

8. Cellule photovoltaïque selon la revendication 3, **caractérisée en ce que** les secondes pastilles d'électrodes (32) ont chacune une longueur et une largeur respectivement comprises entre 0,4 mm et 0,7 mm.

9. Module photovoltaïque, **caractérisé en ce que** le module photovoltaïque comprend du verre, un premier matériau de film, une chaîne de cellules photovoltaïques, un second matériau de film et une feuille arrière, séquentiellement d'une face avant à une face arrière, dans lequel la chaîne de cellules photovoltaïques comprend une pluralité de cellules photovoltaïques, et chacune de la pluralité de cellules photovoltaïques est la cellule photovoltaïque selon l'une quelconque des revendications 1 à 8.

10. Module photovoltaïque selon la revendication 9, **caractérisé en ce que** la pluralité de cellules photovoltaïques est connectée par une ligne d'électrode, et que la ligne d'électrode a un diamètre compris entre 0,25 mm et 0,32 mm.

11. Module photovoltaïque selon la revendication 9, **caractérisé en ce que** le premier matériau de film et/ou le second matériau de film a un poids compris entre 300 g/m² et 500 g/m².
